# EUROPEAN PATENT APPLICATION

(11) **EP 3 905 858 A1**
(43) Date of publication of application: **03.11.2021**
(21) Application number: 19903440.6
(22) Date of filing: 30.09.2019
(51) Int. Cl.: H05K 1/02, G02B 6/12

(54) **CIRCUIT BOARD, MANUFACTURING METHOD AND ELECTRONIC DEVICE**

(30) Priority: 27.12.2018 CN 201811616137
(71) Applicant: ZTE Corporation, Shenzhen, Guangdong 518057 (CN)
(72) Inventor: CHEN, Xiaolin, Shenzhen, Guangdong 518057 (CN); ZHU, Shunlin, Shenzhen, Guangdong 518057 (CN); TIAN, Hao, Shenzhen, Guangdong 518057 (CN); WANG, Yingxin, Shenzhen, Guangdong 518057 (CN); REN, Yonghui, Shenzhen, Guangdong 518057 (CN)
(74) Representative: Mozzi, Matteo
(86) International application number: PCT/CN2019/109555
(87) International publication number: WO 2020/134301

(57) **Abstract**

Provided are a circuit board, a manufacturing method and an electronic device. The circuit board at least includes a first base layer (1). A first planar capacitor set (2) and an optical waveguide (3) are provided in a region at a first side of the first base layer (1). The first planar capacitor set (2) includes at least one pair of planar capacitors. The first planar capacitor set (2) and the at least one optical waveguide (3) are arranged side by side in a direction parallel to a plane in which the first base layer (1) is located. The problem in the conventional art that the high frequency filtering effect of a power supply in an Optical Electronic Printed Circuit Board (OE-PCB) is poor is solved, thereby achieving an effect of improving power source stability of the optical electronic printed circuit board.

## Description

### Cross-Reference to Related Application

The disclosure claims priority to Chinese Patent Application No. 201811616137.4, filed to the China National Intellectual Property Administration on December 27, 2018, the disclosure of which is hereby incorporated by reference in its entirety.

### Technical Field

The disclosure relates to the technical field of circuit boards, for example, a circuit board, a manufacturing method and an electronic device.

### Background

With the explosive growth of data traffic, an electronic circuit system can no longer meet the needs of long line and low loss transmission due to dielectric loss, electromagnetic interference, crosstalk and other factors, therefore, an Optical Electronic Printed Circuit Board (OE-PCB) emerges. The OE-PCB is composed of a traditional PCB layer and an optical waveguide layer which are laminated. By adding an optical waveguide layer to the very mature PCB, the use of circuit board is extended from the existing electrical connection technology to the field of optical transmission. The optical transmission has the advantages of high density integration, low crosstalk, simplified physical design, compatibility with the traditional manufacturing methods, low energy consumption, elimination of EMI, high bandwidth, high speed and so on. Many PCB manufacturers and PCB substrate materials manufacturers in the world have been actively involved in the development of the new technology and market.

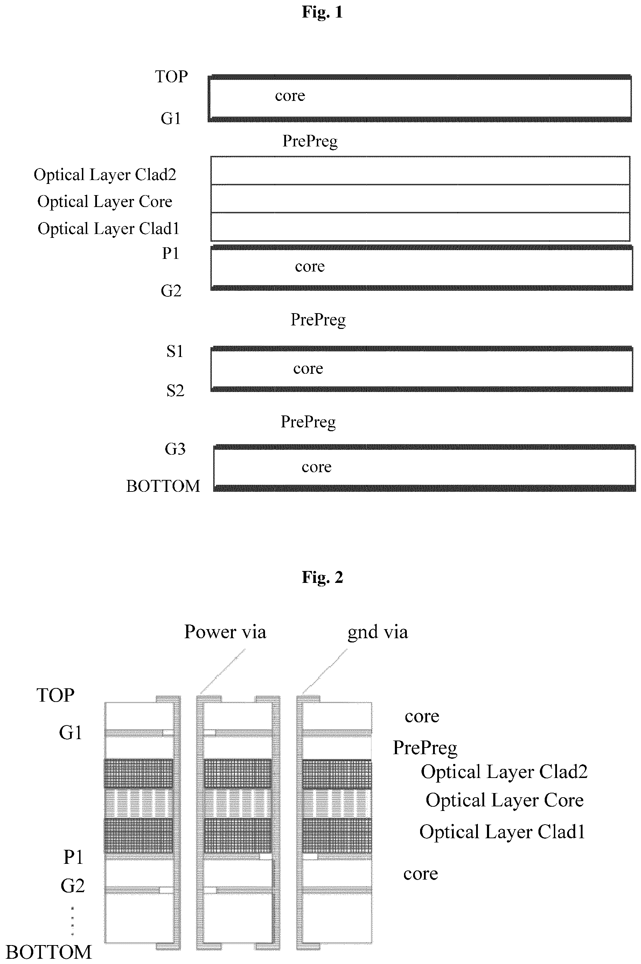

In the conventional art, the OE-PCB uses light for transmission and electricity for calculation. Both light and electricity are important parts in the OE-PCB. While continuously optimizing the efficiency of optical signal transmission, it is also needed to comprehensively consider the operating state of an electrical signal in a high-speed system. A high-speed electronic chip and an optical electronic chip, as the source of optical signals, have low operating voltage and high speed, which puts forward higher requirements for the stability of a power supply system in the whole operating frequency band. It is necessary to ensure that the quality of power supply meets the requirements of devices and systems to make the devices and systems operate stably. A discrete capacitor, as an important part of the traditional filter circuit, can no longer meet the requirement for filtering high frequency noises. The characteristics of the discrete capacitor and parasitic inductance caused by wiring of the discrete capacitor on the surface of the PCB make the discrete capacitor lose its filtering effect in a high frequency band. Although a planar capacitor composed of a power plane and a ground plane which are parallel avoids a parasitic resistance and parasitic inductance generated by a capacitor pin and can filter some high frequency noises, in the conventional art, the parasitic inductance of a power via still significantly affects the filtering effect of the planar capacitor in the high frequency band. Further explanation will be provided with reference to Fig. 1 and Fig. 2. Fig. 1 illustrates a conventional laminated structure of an OE-PCB with eight electrical signal layers and one optical waveguide layer. The optical electronic chip is mounted on the TOP layer, P1 is the power plane, G1, G2 and G3 are the ground planes, and P1 and G2 form the plane capacitor. A power pin of the chip is connected to the power plane P1 through a bonding pad in the TOP layer and a metalized through hole, and a ground pin of the chip is connected to the ground plane G2 through the bonding pad in the TOP layer and the metalized through hole, so starting from the power pin of the chip and ending in the ground pin of the chip, the power pin of the chip, the bonding pad of power supply, the power via, the planar capacitor, the ground via, the bonding pad of ground and the ground pin of the chip form a complete circuit. The planar capacitor provides high frequency filtering for the power supply of the chip, but the via will generate the parasitic inductance, which affects the filtering effect of the planar capacitor. Fig. 2 is a part sectioned view of an OE-PCB, which shows a connection relationship between the power via and the ground via. The power via needs to pass through a core board, a prepreg, two optical layer clads and an optical layer core, and then be connected to the power plane P1. Because the optical waveguide layer contains the core and two clads, and there is a bonding part between the optical waveguide layer and an electrical interconnection part, and these parts have thickness requirements, the total thickness of the optical waveguide layer is larger. A power-ground plane layer pair configured in the electrical interconnection part is vertically far away from the related chip mounted on the surface of the OE-PCB, which makes the effective length of the power via longer, and the parasitic inductance generated by the power via will significantly affect the filtering effect of the plane capacitor in the high frequency band.

For the problem in the conventional art that the high frequency filtering effect of the power supply in the OE-PCB is poor, there is no solution yet.

### Summary

The following is an overview of the theme elaborated in the specification. The overview is not intended to limit the protection scope of the claims.

The disclosure provides a circuit board, a manufacturing method and an electronic device, which may at least solve the problem in the conventional art that the high frequency filtering effect of a power supply in an OE-PCB is poor.

According to an embodiment of the disclosure, a circuit board is provided, which may at least include a first base layer. A first planar capacitor set and at least one optical waveguide are provided in a region at a first side of the first base layer. The first planar capacitor set includes at least one pair of planar capacitors. The first planar capacitor set and the at least one optical waveguide are arranged side by side in a direction parallel to a plane in which the first base layer is located.

According to another embodiment of the disclosure, a method for manufacturing a circuit board is provided, which may include that: in the region at the first side of at least one first base layer, a first planar capacitor set and at least one optical waveguide are formed, wherein the first planar capacitor set and the at least one optical waveguide are distributed side by side in the direction parallel to the plane in which the first base layer is located.

According to yet another embodiment of the disclosure, an electronic device is also provided, which may include the circuit board.

Through the embodiments of the disclosure, the circuit board at least includes a first base layer, the first planar capacitor set and the at least one optical waveguide are provided in the region at the first side of the first base layer, the first planar capacitor set includes at least one pair of planar capacitors, and the first planar capacitor set and the at least one optical waveguide are arranged side by side in the direction parallel to the plane in which the first base layer is located. In this way, a power via on the circuit board does not have to pass through an optical waveguide layer, which greatly shortens the effective length of the power via, thereby reducing parasitic inductance of the power via, and preventing the parasitic inductance of the power via from influencing seriously the high frequency filtering. Therefore, the problem in the conventional art that the high frequency filtering effect of the power supply in the OE-PCB is poor can be solved, thereby achieving the effect of improving the stability of power supply of the OE-PCB.

### Brief Description of the Drawings

The accompanying drawings described herein are used to provide a deeper understanding of the present disclosure, and constitute a part of the present application. The exemplary embodiments of the present disclosure and the description thereof are used to explain the present disclosure. The drawings and the exemplary embodiment do not constitute limitations to the present disclosure. In the drawings:
Fig. 1 is a schematic diagram of a laminated structure of an OE-PCB in the conventional art;
Fig. 2 is a schematic diagram of a connection relationship between a power via and a ground via in the OE-PCB shown in Fig. 1;
Fig. 3 is a schematic diagram of a vertical coupling path of an optical signal output by an optical electronic chip;
Fig. 4 is a structure diagram of a circuit board according to an embodiment of the disclosure;
Fig. 5 is a flowchart of a method for manufacturing a circuit board according to an embodiment of the disclosure;
Fig. 6 is a schematic diagram of a local structure of a circuit board according to a first exemplary implementation of the embodiments of the disclosure;
Fig. 7 is a schematic diagram of the laminated structure of an electrical signal interconnection part in a circuit board according to a first exemplary implementation of the embodiments of the disclosure;
Fig. 8 is a schematic diagram of a local structure of a circuit board according to a second exemplary implementation of the embodiments of the disclosure;
Fig. 9 is a schematic diagram of the laminated structure of an electrical signal interconnection part in a circuit board according to a second exemplary implementation of the embodiments of the disclosure;
Fig. 10 is a schematic diagram of a local structure of a circuit board according to a third exemplary implementation of the embodiments of the disclosure;
Fig. 11 is a schematic diagram of the laminated structure of an electrical signal interconnection part in a circuit board according to a third exemplary implementation of the embodiments of the disclosure; and
Fig. 12 is a schematic diagram of a local structure of a circuit board according to a fourth exemplary implementation of the embodiments of the disclosure.

In the accompanying drawings:
1 is a first base layer;
1-1 is a first surface of the first base layer;
1-2 is a second surface of the first base layer;
2 is a first planar capacitor set;
3 is an optical waveguide;
100 is an optical signal core;
101 and 102 are optical signal clads;
201, 202, 203 and 204 are prepregs;
301 is a ground via;
302 and 303 are power vias;
500, 510, 501, 600 and 800 are electrical signal interconnection PCB (E-PCB);
layer 1 is the first copper foil layer of 600;
layer n is the n-th copper foil layer of 600;
S and S' are surface layers of OE-PCB;
G1, G2, G3, G4 and G5 are ground planes; and
PI, P2 and P5 are power planes.

### Detailed Description

The present disclosure is described below in detail with reference to the drawings and in conjunction with the embodiments. It is to be noted that embodiments in the present application and characteristics in the embodiments may be combined to derive other embodiments not explicitly described.

It is to be noted that the terms "first", "second" and the like in the specification, the claims and the drawings of the present disclosure are used to distinguish similar objects, and are not used to describe a specific sequence or a precedence order.

### First embodiment

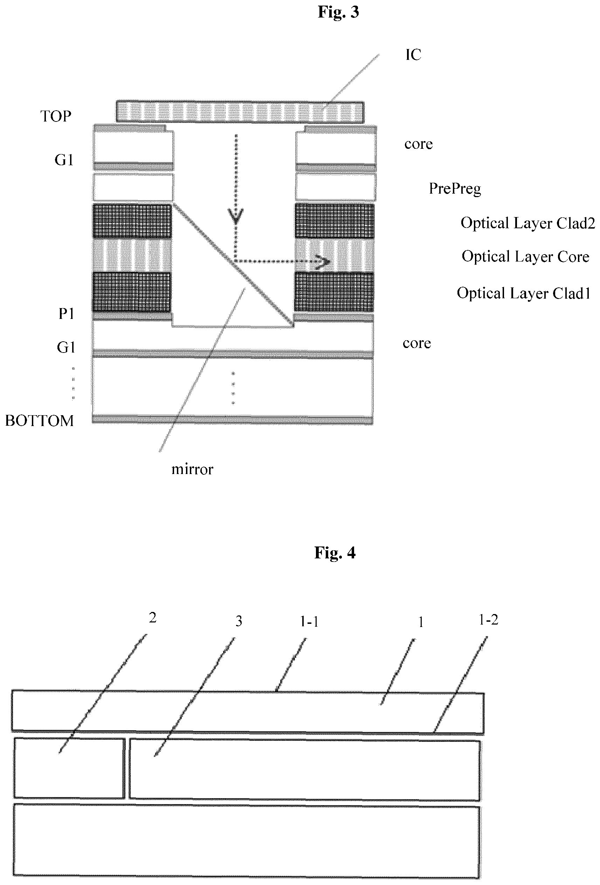

The first embodiment provides a circuit board. Fig. 4 is a structure diagram of a circuit board according to an embodiment of the disclosure. As shown in Fig. 4, the circuit board at least includes one first base layer 1. A first planar capacitor set 2 and an optical waveguide 3 are provided in a region at a first side of the first base layer 1. The first planar capacitor set includes at least one pair of planar capacitors. The first planar capacitor set 2 and the at least one optical waveguide 3 are arranged side by side in a direction parallel to a plane in which the first base layer 1 is located.

Through the embodiment of the disclosure, a power via on the circuit board does not have to pass through an optical waveguide layer, which greatly shortens the effective length of the power via, thereby reducing parasitic inductance of the power via, and preventing the parasitic inductance of the power via from influencing seriously the high frequency filtering. Therefore, the problem in the conventional art that the high frequency filtering effect of a power supply in an OE-PCB is poor can be solved, thereby achieving the effect of improving the stability of power supply of the OE-PCB.

It is to be noted that the first base layer 1 of the present embodiment may be understood as a board structure or a layer structure used for bearing various structures in an OE-PCB. For example, the first base layer may be a layer of insulating dielectric plate on which a variety of other structures may be formed. For example, a copper foil may be formed on the surface of the first base layer, and the formed copper foil may be used for electrical signal transmission; or the first base layer may be drilled, and mounted with a component.

In an implementation, the first base layer 1 may include a first surface 1-1 and a second surface 1-2. The first surface 1-1 may be a component mounting surface, and the first planar capacitor set and the at least one optical waveguide may be constructed on the second surface 1-2. Other structures of the OE-PCB may be superimposed based on the first base layer.

It is to be noted that in an implementation, the OE-PCB of the present embodiment shall include the first planar capacitor set and at least one optical waveguide, and the first planar capacitor set and the at least one optical waveguide are arranged side by side in the direction parallel to the plane in which the first base layer is located. In a case where the OE-PCB includes two or more than two optical waveguides, either part of the optical waveguides or all of the optical waveguides are distributed side by side in the direction parallel to the plane in which the first base layer is located.

In an implementation, the first planar capacitor set may be a capacitor set structure arranged around the at least one optical waveguide, that is, the projection of the first planar capacitor set on the plane in which the first base layer is located may be distributed around the projection of one or more optical waveguides on the plane in which the first base layer is located.

It is to be noted that the first planar capacitor set 2 and the at least one optical waveguide 3 are arranged side by side in the direction parallel to the plane in which the first base layer 1 is located, which does not limit that the first planar capacitor set and the at least one optical waveguide strictly follow the absolute consistency of thickness or height, and may allow a reasonable error in the thickness or height. For example, the outer surface of the at least one optical waveguide may be fixed using a prepreg, and the presence of the prepreg may cause that the thicknesses or heights of the first planar capacitor set and the at least one optical waveguide are not absolutely consistent. This situation will neither affect the realization of the implementations of the disclosure nor affect the corresponding technical effects of the embodiments of the disclosure.

In an implementation, the first planar capacitor set is contacted and connected with the first base layer.

It is to be noted that in an implementation, the first planar capacitor set may be directly contacted and connected with the first base layer or arranged adjacent to the first base layer. In this way, the length of the power via may be shortened to the maximum extent, thereby minimizing parasitic inductance of the via, and preventing the parasitic inductance of the via from influencing seriously the high frequency filtering. For example, at the first side of the first base layer, a pair of planar capacitors may be arranged directly close to the first base layer, which may effectively shorten the length of the via.

In an implementation, the first planar capacitor set includes a first ground plane, which is contacted and connected with the first base layer.

It is to be noted that the circuit board may include multiple ground planes, and a first ground plane may be connected with other ground planes through a number of ground vias, thereby expanding a heat dissipation area, and achieving the effect of fast heat dissipation. The first ground plane may also be connected to other structures to help dissipate heat from the other structures.

In an implementation, the at least one optical waveguide is contacted and connected with the first base layer.

It is to be noted that the at least one optical waveguide may be directly contacted and connected with the inner surface of the first base layer, which may significantly shorten the length of a vertical coupling channel of an optical signal and improve the coupling accuracy of optical transmission.

In an implementation, a first metal layer is provided between the at least one optical waveguide and the first base layer. The first metal layer is contacted and connected with the first base layer and the at least one optical waveguide respectively.

It is to be noted that the first metal layer can not only provide a stable support for the at least one optical waveguide, but also provide a reference plane for the at least one optical waveguide, so as to control the thickness of the at least one optical waveguide and improve the manufacturing accuracy of the at least one optical waveguide. The first metal layer may be flat, so that the at least one optical waveguide has good flatness, and thus an optical transmission loss is reduced. A signal network may not be provided on the first metal layer.

In an implementation, the first metal layer is connected to the ground plane included in the circuit board.

The first metal layer may have good thermal conductivity, and the connection with the ground plane helps dissipate heat from the at least one optical waveguide, so as to prevent the thermal deformation of the at least one optical waveguide from increasing a signal transmission loss. In addition, the first metal layer may be set relatively thin, which can help dissipate heat from the at least one optical waveguide without significantly increasing the length of the vertical coupling channel of the optical signal, so the optical coupling accuracy can be basically maintained.

In an implementation, the first metal layer is connected to a ground plane in the first planar capacitor set.

It is to be noted that because the first planar capacitor set and the at least one optical waveguide are arranged side by side, the first metal layer may be conveniently connected to the ground plane in the first planar capacitor set, which may reduce the manufacturing difficulty and make the overall structure of the circuit board compact. For example, the first metal layer may be connected with the above first ground plane.

In an implementation, a second planar capacitor set is provided in a region at a second side of the first base layer. The second planar capacitor set includes at least one pair of planar capacitors.

It is to be noted that in a case where there are more power sources needing to be optimized on the circuit board, a large number of power distributions cannot be supported only relying on the first planar capacitor set. The second planar capacitor set can increase the types of optimized power supply and increase power throughput.

It is to be noted that the second side of the first base layer may be on the other side of the first base layer relative to the first side of the first base layer. For example, the region at the first side of the first base layer may refer to the region above the first base layer, and the region at the second side may refer to the region below the first base layer; or, the region at the first side of the first base layer may refer to the region below the first base layer, and the region at the second side may refer to the region above the first base layer.

In an implementation, the second planar capacitor set is contacted and connected with the first base layer.

It is to be noted that the first planar capacitor set and the second planar capacitor set may be two completely independent capacitor sets, or may be adjacent to each other. For example, the first planar capacitor set and the second planar capacitor set may share a power plane or ground plane at an adjacent position. The structure of the circuit board can be made more compact by making the second planar capacitor set contacted and connected with the first base layer, thereby avoiding the excessive length of the power via.

In an implementation, the second planar capacitor set includes a second ground plane, and the second ground plane is contacted and connected with the first base layer; or the second planar capacitor set includes a first power plane, and the first power plane is contacted and connected with the first base layer.

In an implementation, the via on the circuit board may be provided in a bonding pad of the circuit board. In this way, there is no lead between the bonding pad and the via, thereby eliminating the parasitic inductance of the lead and further optimizing the filtering effect.

In an implementation, the power plane of the planar capacitor included in the circuit board may be provided with one or multiple types of power networks, and the multiple types of power networks are isolated from each other. It is to be noted that this can improve the capability of the circuit board to support various types of power networks.

In an exemplary implementation, a first component is mounted on an outer surface of the circuit board. A power pin and a ground pin of the first component are connected with the planar capacitor included in the circuit board through a metalized hole wall. The metalized hole wall is arranged in the via and distributed between the planar capacitor included in the circuit board and the outer surface of the circuit board in a direction parallel to an axis of the via.

It is to be noted that the metalized hole wall may be distributed only between the planar capacitor and the outer surface of the circuit board, that is, the metalized hole wall except the effective part of the above metalized via is removed, which is conducive to reducing crosstalk coupling between the vias.

In an exemplary implementation, the first planar capacitor set includes the following structure: a structure formed by one or more insulating dielectric layers spaced successively among multiple power planes and ground planes.

It is to be noted that the capacitor set may be of a structure in which a power plane, an insulation layer, a ground plane, another insulating layer, another power plane and so on are arranged alternately. The capacitor pair may share the power plane or the ground plane. The planar capacitor set can increase the types of optimized power supply and increase the power throughput.

It is to be noted that the circuit board provided in the present embodiment and exemplary implementations may include an upper base layer and a lower base layer. Any above structure may be provided in the region below the inner surface of the upper base layer, and any above structure may also be provided in the region above the inner surface of the lower base layer; or, any above structure is provided in both the region below the upper base layer and the region above the lower base layer. Moreover, the structures at the two sides of the circuit board may be symmetrical or mirrored, or may be asymmetric. In a case where the circuit board includes multiple planar capacitor sets and multiple optical waveguides, the capacity and capability of the circuit board to process the electrical signal and the optical signal can be improved.

To better explain the embodiments of the disclosure, the following examples are given in combination with the exemplary implementations.

In the field of PCB design, the parasitic inductance L caused by the via is equal to 5.08H[ln(4H/D)+1], where H is the length of the via, and D is the aperture of the via. It can be seen from the formula that the length and the aperture of the via are the main factors affecting the parasitic inductance. To reduce the parasitic inductance, the via with a large aperture is used, or the length of the via should be as short as possible. However, a high-speed chip is usually packaged with a high density, and the via with a large aperture is often limited during wiring, so the embodiments of the disclosure reduce the parasitic inductance of the via by shortening the length of the via.

In addition, in the OE-PCB, an optical electronic chip interconnects the optical signal to the optical waveguide layer through vertical coupling, which requires the control of drilling depth of the coupling channel, and as a hole depth increases, a machining tolerance increases, so the deeper the hole is, the lower the coupling accuracy and the greater the coupling loss. Fig. 2, which is a part sectioned view, shows a path that the optical signal output by the optical electronic chip in the OE-PCB is vertically coupled to an optical layer core, as shown by the dotted lines and arrows in the figure. The mirror in the figure is a device that changes an optical transmission direction. The hole depth affects the position of the mirror, thus affecting the position of the optical signal entering the optical waveguide layer. Only the optical signal entering the optical layer core can be transmitted efficiently. In the embodiments of the disclosure, the waveguide layer is positioned close to the component mounting surface, so as to obtain a higher coupling accuracy.

The embodiments of the disclosure provide a PCB structure, which can not only optimize a power supply system of the optical electronic chip, reduce the influence of high frequency noises on the power supply of the chip, guarantee the stable operation of the system and the reliability of an optical signal source, but also meet the high-precision alignment of the vertically coupled optical waveguide and reduce the coupling loss.

The PCB structure in the embodiments of the disclosure includes at least one pair of ground plane/power plane layer pairs (hereinafter referred to as layer pair). The ground planes/power planes are connected by means of the prepreg (insulating dielectric layer). The ground plane in the layer pair is located at the copper foil layer on one side of a core board, the component mounting surface is located at the copper foil layer on the other side of the core board, and the ground plane in the layer pair is connected with the copper foil on the substrate of the at least one optical waveguide. One or more power networks may exist on the power plane in the layer pair. In a case where there is more one power network, copper sheets where the power networks are located are isolated from each other. Except the power copper sheet, the interconnection of some electrical signals may also exist on the power plane. It is to be noted that the substrate of the optical waveguide is a supporting part of the optical waveguide, and the optical waveguide needs to be constructed on the substrate. In the embodiments of the disclosure, the above core board is taken as the substrate of the optical waveguide.

The PCB structure in the embodiments of the disclosure also includes at least one optical waveguide layer to which the optical signal is interconnected, through the vertical coupling, from the chip located on the component mounting surface. It is to be noted that the optical waveguide layer includes a core, a lower clad and an upper clad. The refractive index of the core is t0, the refractive index of the lower clad is t1, and the refractive index of the upper clad is t2, where t1 is equal to t2 or t1 is not equal to t2, and t1 and t2 are less than t0.

It is to be noted that in the present embodiment, the core board may be understood as a board with a copper foil layer on the surface and a solid insulating medium in the middle, which is used for manufacturing the circuit board. The insulating dielectric layer in the middle of the core board is equivalent to "the first base layer" in the above embodiment. The copper foil layer at the position corresponding to the optical waveguide on the substrate is equivalent to "the first metal layer" in the above embodiment.

In the embodiments of the disclosure, the power pin of a component is connected to the power supply plane through the bonding pad on the component mounting surface and the metalized through hole, and the ground pin of the component is connected to the ground plane through the bonding pad on the component mounting surface and the metalized through hole. In addition, in an implementation, the metalized hole wall except the effective part of the metalized through hole may be removed to reduce the crosstalk coupling between the vias.

The PCB structure provided in the embodiments of the disclosure can make the OE-PCB have a planar capacitor with small parasitic inductance while guaranteeing the vertical coupling alignment accuracy of the optical waveguide, thereby reducing the influence of high frequency noises on the power supply of a chip and making the power supply of a system more stable. At the same time, the shortened via is also conducive to reducing the crosstalk coupling between the vias. Moreover, the copper foil on the substrate of the optical waveguide in the embodiments of the disclosure is connected to the ground plane, so that the heat generated in the operating process is dissipated rapidly through the ground plane, which prevents the optical waveguide from being easily deformed by heat and reduces transmission loss. The thickness of the OE-PCB in the embodiments of the disclosure may be reduced by at least the thickness occupied by one layer pair, and is thinner than the traditional OE-PCB, which is conducive to the miniaturization of system.

It is to be noted that in the following implementations, the refractive index of the optical signal core is t0, the refractive indexes of the optical signal clads 101 and 102 are t1 and t2 respectively, where t1 is equal to t2 or t1 is not equal to t2, and t1 and t2 are less than t0. There reference numerals 500, 510, 501 and 600 represent E-PCB for electrical signal interconnection. The number of layers of 500, 510 and 501 is 2, which is the core board (the core board is also called core), and the number of layers of 600 is n (n is an even number and greater than or equal to 2). S and S' are surface layers of the OE-PCB, used for mounting and supporting of the component as well as the interconnection of some electrical signals.

### First exemplary implementation

In the present exemplary implementation, the optical waveguide layer and the planar capacitor are constructed in parallel on the same substrate. The planar capacitor formed by the power plane P1 and the ground plane G1 (equivalent to the first ground plane in the above embodiment) is immediately adjacent to the component mounting surface S, and the power pin of the chip only needs to pass through the core board 500 and the prepreg 201 to be connected with the power plane, which reduces the effective length of the power via by more than 50%. At the same time, the part of the power plane PI, which corresponds to the optical waveguide, is hollow to expose the ground plane G1. The optical waveguide layer is constructed on an exposed ground copper sheet (the exposed ground copper sheet is equivalent to the first metal layer in the above embodiment). In this way, the optical waveguide layer and the mounting surface are separated by only the thickness of the core board 500, which facilitates the control of the hole depth of the coupling channel. The parts formed above are connected to an electrical interconnection part 600 through the prepreg 203 to constitute the OE-PCB in the embodiments.

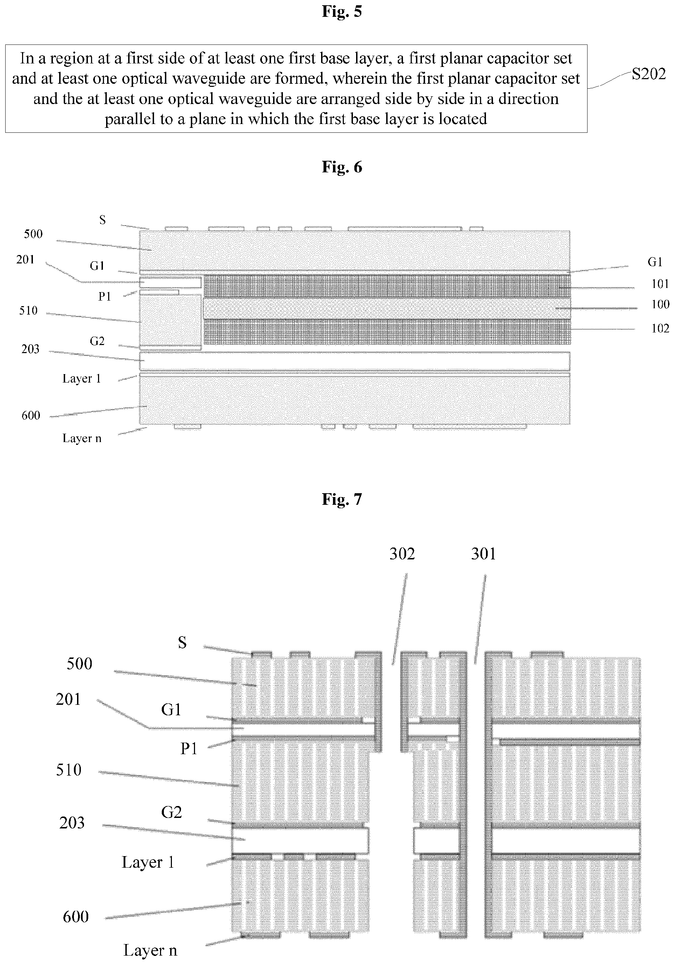

Fig. 6 is a schematic diagram of a local structure of a circuit board according to the first exemplary implementation of the embodiments of the disclosure, showing a connection relationship between the electrical signal interconnection part and the optical waveguide part. Fig. 7 is a schematic diagram of the laminated structure of an electrical signal interconnection part in a circuit board according to a first exemplary implementation of the embodiments of the disclosure, showing the laminated structure of the electrical signal interconnection part and a connection relationship between the ground via and the power via.

As shown in Fig. 6 and Fig. 7, the copper foils on both sides of the core board 500 (the insulating dielectric layer in the middle of the core board 500 is equivalent to "the first base layer" in the above embodiment) are respectively made to have the pattern of the component mounting surface S and the pattern of the ground plane G1, the part corresponding to the optical waveguide in the ground plane G1 is provided with a complete copper foil, and the copper foil is connected to the ground plane of the electrical signal part. The copper foils on both sides of the core board 510 are respectively made to have the pattern of the power plane P1 and the pattern of the ground plane G2, and the parts corresponding to the optical waveguide in the power plane P1 and the ground plane G2 are hollow. The power plane P1 and the ground plane G1 are connected through the prepreg 201, the ground pin of the component is connected to the above ground plane G1 through the bonding pad on the component mounting surface S and the metalized through hole 301, and the power pin of the component is connected to the above power plane P1 through the bonding pad on the component mounting surface S and the metalized through hole 302. The parts corresponding to the optical waveguide in the core board 510 and the prepreg 201 are hollow to expose the copper foil of the ground plane G1. The exposed copper foil of the ground plane G1 is connected to the optical layer clad 101. The optical layer clad 101 is connected to the optical layer core 100. An optical layer core pattern is made in the optical layer core 100. The optical layer core 100 is connected to the optical layer clad 102. The above parts and the electrical interconnection part 600 prepared in advance are connected through the prepreg 203.

In addition, the metalized hole wall except the effective part of the above metalized via 302 may be removed. The metalized vias 301 and 302 may also be placed in the corresponding bonding pad on the component mounting surface S, that is, there is no lead between the bonding pad and the corresponding via.

The connection relationship between the electrical signal interconnection part and the optical waveguide part in the present embodiment is shown in Fig. 6.

The layer 1 in Fig. 6 may have interconnection of any electrical signal. An exemplary implementation is that the position corresponding to the optical waveguide in the layer 1 is the ground plane to improve the heat dissipation efficiency, and other positions may be provided with other electrical signals.

The layer n in Fig. 6 is another component mounting surface opposite to the component mounting surface S in the PCB.

In the present embodiment, the power plane P1 and the ground plane G1 may form a planar capacitor, and the power plane P1 and the ground plane G2 may also form a planar capacitor. The planar capacitor set formed by the two planar capacitors is equivalent to "the first planar capacitor set" in the above embodiment.

In the present embodiment, the medium between the power plane P1 and the ground plane G2 of the core board 510 may also be an insulating medium with a high dielectric constant. The insulating medium may be, but is not limited to, epoxy resin, glass fiber, polyimide, and barium titanate. The use of insulating medium with a high dielectric constant may obtain a higher capacitance value, so that the filter range of the planar capacitor is larger.

The laminated structure of the electrical signal interconnection part in the present embodiment and the connection relationship between the ground via and the power via are shown in Fig. 7.

In Fig. 7, 301 and 302 are provided only to indicate the connection relationship between ground via and the power via, and should not be understood as the only two ground/power vias in the OE-PCB in the present embodiment. One or more than one power network may exist on the power plane P1.

In a case where more than one power network exists, the copper sheets where the power networks are located are isolated from each other. Both the upper and lower parts of the P1 are adjacent to the ground plane, which makes P1 an excellent signal layer, so there may be the interconnection of some electrical signals on the P1 in addition to the power copper sheet.

The ground via 301 in Fig. 7 may be connected to multiple ground planes in the OE-PCB. The layer n in Fig. 7 is another component mounting surface opposite to the component mounting surface S in the PCB.

In the present embodiment, the power plane is close to the component mounting surface, the power via does not have to pass through the optical waveguide layer, and compared with the conventional OE-PCB, the effective length of the power via is shorter, so the parasitic inductance generated by the power via is smaller. At the same time, the effective length of the via is shortened, and the metalized hole wall except the effective part of the via is removed, which is also conducive to reducing the crosstalk coupling between the via.

The total thickness of the OE-PCB in the present embodiment is reduced by the thickness occupied by one layer pair, so the OE-PCB is thinner than the traditional OE-PCB. If the total thickness is kept constant, more signal layers may be arranged to facilitate the design of more functions.

The OE-PCB in the present embodiment has multiple ground planes, and the interconnection between the ground planes is realized by the ground via, so the heat can be rapidly dissipated. The optical waveguide layer in the present embodiment is constructed on the copper foil connected to the ground plane, and is less affected by heat than being constructed at other positions.

### Second exemplary implementation

In the exemplary implementation 2, a core board with the power plane P2 on one side and the ground plane G3 on the other side is added on the basis of the planar capacitor in the first exemplary implementation. In a case where there are more types of power supply, the multiple types of power supply may be shared through two power planes. In a case where the power throughput is large, the power throughput may also be shared through two power planes. The added core board is also parallel to the optical waveguide layer.

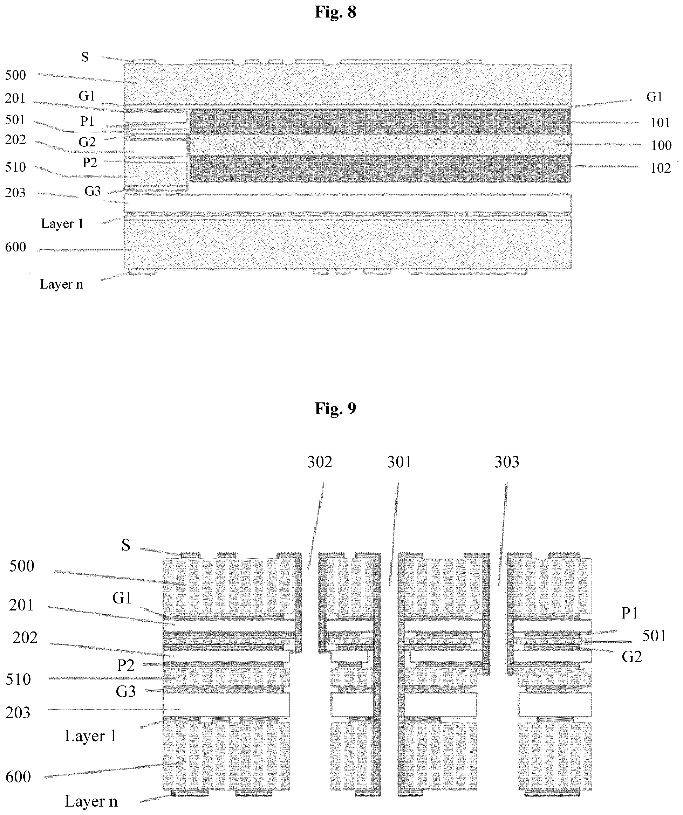

Fig. 8 is a schematic diagram of a local structure of a circuit board according to the second exemplary implementation of the embodiments of the disclosure, showing the connection relationship between the electrical signal interconnection part and the optical waveguide part. Fig. 9 is a schematic diagram of the laminated structure of an electrical signal interconnection part in a circuit board according to the second exemplary implementation of the embodiments of the disclosure, showing the laminated structure of the electrical signal interconnection part and the connection relationship between the ground via and the power via.

As shown in Fig. 8 and Fig. 9, the copper foils on both sides of the core board 500 (the insulating dielectric layer in the middle of the core board 500 is equivalent to "the first base layer" in the above embodiment) are respectively made to have the pattern of the component mounting surface S and the pattern of the ground plane G1, the part corresponding to the optical waveguide in the ground plane G1 is provided with a complete copper foil, and the copper foil is connected to the ground plane of the electrical signal part.

The copper foils on both sides of the core board 501 are respectively made to have the pattern of the power plane P1 and the pattern of the ground plane G2, and in the power plane P1 and the ground plane G2, the parts corresponding to the optical waveguide are hollow.

The ground plane G1 and the power plane P1 are connected through the prepreg 201.

The copper foils on both sides of the core board 510 are respectively made to have the pattern of the power plane P2 and the pattern of the ground plane G3, and in the power plane P2 and the ground plane G3, the parts corresponding to the optical waveguide are hollow.

The ground plane G2 and the power plane P2 are connected through the prepreg 202.

The ground pin of the component is connected to the above ground plane G1 and ground plane G2, through the bonding pad on the component mounting surface S and the metalized through hole 301, and the power pin of the component is connected to the above power plane P1 or power plane P2 through the bonding pad on the component mounting surface S and the metalized through hole 302 or 303.

In the core boards 510 and 501, and the prepregs 201 and 202, the parts corresponding to the optical waveguide are hollow to expose the copper foil of the ground plane G1.

The exposed copper foil of the ground plane G1 is connected to the optical layer clad 101.

The optical layer clad 101 is connected to the optical layer core 100.

The optical layer core pattern is made in the optical layer core 100.

The optical layer core 100 is connected to the optical layer clad 102.

The above parts and the electrical interconnection part 600 prepared in advance are connected through the prepreg 203.

In addition, in an exemplary implementation, the metalized hole wall except the effective part of the above metalized vias 302 and 303 may be removed. The metalized vias 301, 302 and 303 may also be placed in the corresponding bonding pad on the component mounting surface S, that is, there is no lead between the bonding pad and the corresponding via.

The connection relationship between the electrical signal interconnection part and the optical waveguide part in the present embodiment is shown in Fig. 8. The layer 1 in Fig. 8 may have interconnection of any electrical signal. An exemplary implementation is that the position corresponding to the optical waveguide in the layer 1 is the ground plane to improve the heat dissipation efficiency, and other positions may be provided with other electrical signals. The layer n in Fig. 8 is another component mounting surface opposite to the component mounting surface S in the PCB.

In the present embodiment, the power plane P1 and the ground plane G1 may form a planar capacitor, and the power plane P1 and the ground plane G2 may also form a planar capacitor. The power plane P2 and the ground plane G2 may form a planar capacitor, and the power plane P2 and the ground plane G3 may also form a planar capacitor. The planar capacitor set formed by these planar capacitors is equivalent to "the first planar capacitor set" in the above embodiment.

In the present embodiment, between the power plane P1 and the ground plane G2, the medium of the core board 501 may also be an insulating medium with a high dielectric constant. The insulating medium may be, but is not limited to, epoxy resin, glass fiber, polyimide, and barium titanate. The use of insulating medium with a high dielectric constant may obtain a higher capacitance value, so that the filter range of the planar capacitor is larger.

The laminated structure of the electrical signal interconnection part in the present embodiment and the connection relationship between the ground via and the power via are shown in Fig. 9.

In Fig. 9, 301, 302 and 303 are provided only to indicate the connection relationship between ground via and the power via, and should not be understood as the only three ground/power vias in the OE-PCB.

One or more than one power network may exist on both the power plane P1 and the power plane P2. In a case where more than one power network exists on the same plane, the copper sheets where the power networks are located are isolated from each other. Both the upper and lower parts of the P1 and the P2 are adjacent to two ground planes, so the P1 and P2 are also the excellent signal layers, therefore, except the power copper sheet, there may be the interconnection of some electrical signals on the P1 and the P2.

The ground via 301 in Fig. 9 may be connected to multiple ground planes in the OE-PCB.

The layer n in Fig. 9 is another component mounting surface opposite to the component mounting surface S in the PCB.

Compared with the first exemplary implementation, a pair of power/ground planes is added in the present implementation, which is especially applicable to the design of a wide variety of power networks or a large power throughput requirement.

### Third exemplary implementation

Based on the first exemplary implementation, in the present embodiment, a similar structure 700 is constructed with the core board where another component mounting surface S' is located as the substrate, and the structure 700 is connected through the prepreg 203. Both mounting surfaces of the OE-PCB in the present embodiment may be equipped with optical electronic chips. More optical channels are added in the present embodiment, and is also applicable to the design of a wide variety of power networks.

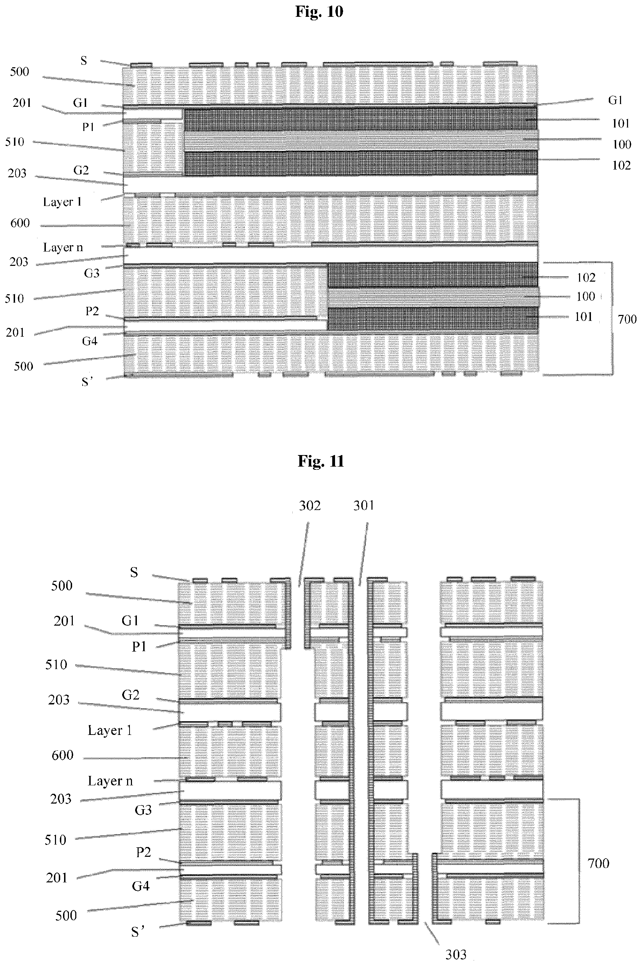

Fig. 10 is a schematic diagram of a local structure of a circuit board according to the third exemplary implementation of the embodiments of the disclosure, showing the connection relationship between the electrical signal interconnection part and the optical waveguide part. Fig. 11 is a schematic diagram of the laminated structure of an electrical signal interconnection part in a circuit board according to the third exemplary implementation of the embodiments of the disclosure, showing the laminated structure of the electrical signal interconnection part and the connection relationship between the ground via and the power via.

As shown in Fig. 10 and Fig. 11, the copper foils on both sides of the core board 500 (the insulating dielectric layer in the middle of the core board 500 is equivalent to "the first base layer" in the above embodiment) are respectively made to have the pattern of the component mounting surface S and the pattern of the ground plane G1, the part in the ground plane G1, which corresponds to the optical waveguide, is provided with a complete copper foil, and the copper foil is connected to the ground plane of the electrical signal part.

The copper foils on both sides of the core board 510 are respectively made to have the pattern of the power plane P1 and the pattern of the ground plane G2, and in the power plane P1 and the ground plane G2, the parts corresponding to the optical waveguide are hollow.

The power plane P1 and the ground plane G1 are connected through the prepreg 201. The ground pin of the component is connected to the above ground plane G1 through the bonding pad on the component mounting surface S and the metalized through hole 301, and the power pin of the component is connected to the above power plane P1 through the bonding pad on the component mounting surface S and the metalized through hole 302.

In the core board 510 and the prepreg 201, the parts corresponding to the optical waveguide are hollow to expose the copper foil of the ground plane G1.

The exposed copper foil of the ground plane G1 is connected to the optical layer clad 101.

The optical layer clad 101 is connected to the optical layer core 100.

The optical layer core pattern is made in the optical layer core 100.

The optical layer core 100 is connected to the optical layer clad 102.

The above structure is also arranged at the other component mounting surface S' to obtain another component 700. The other component mounting surface S' is the mounting surface opposite to the component mounting surface S. In the component 700, the power plane is P2, and the ground planes are G3 and G4. In the component 700, the power pin of the component is connected to the power plane P2 through the bonding pad on the component mounting surface S' and the metalized through hole 303.

The above parts, the electrical interconnection part 600 prepared in advance and the component 700 are connected through the prepreg 203.

In addition, in an exemplary implementation, the metalized hole wall except the effective part of the above metalized vias 302 and 303 may be removed. The metalized vias 301, 302 and 303 may also be placed in the corresponding bonding pads on the component mounting surfaces S and S', that is, there is no lead between the bonding pad and the corresponding via.

The connection relationship between the electrical signal interconnection part and the optical waveguide part in the present embodiment is shown in Fig. 10. The layer 1 and the layer n in Fig. 10 may have interconnection of any electrical signal. An exemplary implementation is that the positions in the layer 1 and the layer n, which correspond to the optical waveguide, are the ground plane to improve the heat dissipation efficiency, and other positions are provided with other electrical signals.

In the present embodiment, the power plane P1 and the ground plane G1 may form a planar capacitor, and the power plane P1 and the ground plane G2 may also form a planar capacitor. The power plane P2 and the ground plane G3 may form a planar capacitor, and the power plane P2 and the ground plane G4 may also form a planar capacitor. The planar capacitor set formed by the G1\P1\G2 planar capacitors is equivalent to "the first planar capacitor set" in the above embodiment, and the planar capacitor set formed by the G3\P2\G4 planar capacitors is also equivalent to "the first planar capacitor set" in the above embodiment.

In the present embodiment, between the power plane P1 and the ground plane G2, and between the power plane P2 and the ground plane G3, the medium of the core board 510 may also be an insulating medium with a high dielectric constant. The insulating medium may be, but is not limited to, epoxy resin, glass fiber, polyimide, and barium titanate. The use of insulating medium with a high dielectric constant may obtain a higher capacitance value, so that the filter range of the planar capacitor is larger.

The laminated structure of the electrical signal interconnection part in the present embodiment and the connection relationship between the ground via and the power via are shown in Fig. 11.

In Fig. 11, 301, 302 and 303 are provided only to indicate the connection relationship between ground via and the power via, and should not be understood as the only three ground/power vias in the OE-PCB of the present embodiment.

One or more than one power network may exist on both the power plane P1 and the power plane P2. In a case where more than one power network exists on the same plane, the copper sheets where the power networks are located are isolated from each other. Both the upper and lower parts of the P1 and the P2 are adjacent to two ground planes, which makes the P1 and the P2 excellent signal layers, therefore, except the power copper sheet, there may be the interconnection of some electrical signals on the P1 and the P2.

The ground via 301 in Fig. 11 may be connected to multiple ground planes in the OE-PCB.

Compared with the first optical implementation, a pair of power/ground planes is added in the embodiments of the disclosure, which can meet the situation of more types of power supply. Moreover, the embodiments of the disclosure have two optical waveguide layers, which can provide more optical transmission channels.

### Fourth exemplary implementation

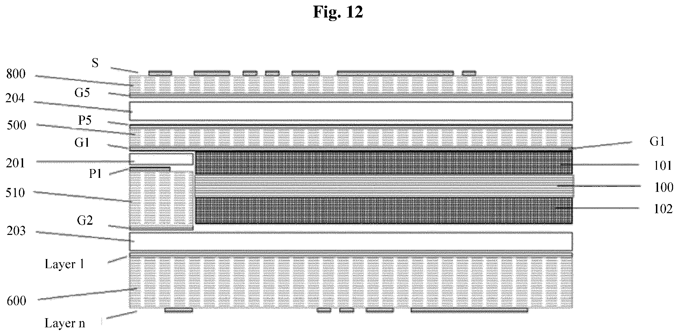

Fig. 12 is a schematic diagram of a local structure of a circuit board according to the fourth exemplary implementation of the embodiments of the disclosure. As shown in Fig. 12, the present embodiment makes some changes based on the first exemplary implementation, which include that: a core board 800 is added above the core board 500 of the circuit board in the first embodiment, and the core board 800 and the core board 500 are connected by using the prepreg 204. The component mounting surface S is made on the outer surface of the core board 800. The pattern of the ground plane G5 is made on the inner surface of the core board 800. The pattern of the power plane P5 and the pattern of the ground plane G1 are respectively made on the copper foils on two sides of the core board 500. There is a complete copper foil at the part corresponding to the optical waveguide in the copper foil where the ground plane G1 is located. The copper foil is connected to the ground plane of the electrical signal part, and a signal network may not be set on the copper foil. The remainder of the implementation is the same as the first embodiment.

A core board 800 is added, and a ground plane G5 is made on the core board 800. The ground plane G5 and the power plane P5 made on the core board 500 may form a planar capacitor, the power plane P5 and the ground plane G1 may also form a planar capacitor (the planar capacitor formed by the P5 and the G5 is equivalent to "the first planar capacitor set" in the above embodiment), and the planar capacitor can increase the types of optimized power supply and increase the power throughput.

Similarly, in other exemplary implementations, a structure similar to the core board 800 may also be added, and a pair of planar capacitors may be formed on the outer surface of the core board 500, thereby increasing the types of optimized power supply and increasing the power throughput, which will not be repeated here.

The present embodiment also provides an electronic device, which includes any above circuit board structure. The specific examples in the present embodiment may refer to the examples described in the above embodiments and exemplary embodiments, and will not be repeated here.

### Second embodiment

The present embodiment provides a method for manufacturing the circuit board in the above embodiment. Fig. 5 shows a method for manufacturing a circuit board according to an embodiment of the disclosure. As shown in Fig. 5, the method includes that: in a region at a first side of at least one first base layer, a first planar capacitor set and at least one optical waveguide are formed, wherein the first planar capacitor set and at least one optical waveguide are arranged side by side in a direction parallel to a plane in which a first base layer is located.

With the circuit board obtained by the above method, the via on the circuit board does not have to pass through the optical waveguide, which greatly shortens the effective length of the via, thereby reducing the parasitic inductance of the via, and preventing the parasitic inductance of the via from influencing seriously the high frequency filtering. Therefore, the problem in the conventional art that the high frequency filtering effect of the power supply in the OE-PCB is poor can be solved, thereby achieving the effect of improving the stability of the circuit board.

In an implementation, the method further includes the following operation.

A contacted and connected state is formed between the first planar capacitor set and the first base layer.

In an implementation, the operation that the contacted and connected state is formed between the first planar capacitor set and the first base layer includes that: the contacted and connected state is formed between a first ground plane and the first base layer. The first planar capacitor set includes the first ground plane.

In an implementation, the method further includes that: the optical waveguide is contacted and connected with the first base layer.

In an implementation, the method further includes that: the first metal layer is formed between the optical waveguide and the first base layer. The first metal layer is contacted and connected with the first base layer and the optical waveguide respectively.

In an implementation, the method further includes that: the first metal layer is connected to the ground plane included in the circuit board.

In an implementation, the method further includes that: the first metal layer is connected to the ground plane in the first planar capacitor set.

In an implementation, the method further includes that: a second planar capacitor set is formed in a region at a second side of the first base layer. The second planar capacitor set includes at least one pair of planar capacitors.

In an implementation, the method further includes that: a contacted and connected state is formed between the second planar capacitor set and the first base layer.

In an implementation, the operation that the contacted and connected state is formed between the second planar capacitor set and the first base layer includes that: the contacted and connected state is formed between a second ground plane and the first base layer, wherein the second planar capacitor set includes the second ground plane; or, the contacted and connected state is formed between a first power plane and the first base layer, wherein the second planar capacitor set includes the first power plane.

In an implementation, the method further includes that: the via on the circuit board is arranged in the bonding pad of the circuit board.

In an implementation, the method further includes that: the power plane of the planar capacitor included in the circuit board is provided with one or multiple types of power networks. The multiple types of power networks are isolated from each other.

In an exemplary implementation, the method further includes that: one or more insulating dielectric layers are successively spaced among multiple power planes and ground planes to form the first planar capacitor set.

It is to be noted that the method provided in the present embodiment is the method for manufacturing the circuit board in the above embodiment, so the above embodiments of the circuit board are applicable to the method in the present embodiment and can achieve the same or similar technical effects.

It is to be noted that "forming" in the above manufacturing method may be understood as a change of structure or a change of state between structures, and "forming" does not necessarily mean a specific actual action, but may also be a combination of multiple/various actual actions. As long as the methods and means used can form the state between the structures described in the above manufacturing method, they shall fall within the scope of protection of this patent.

The above is only the exemplary embodiments of the disclosure and not intended to limit the disclosure; for those having ordinary skill in the art, the disclosure may have various modifications and changes. Any modifications, equivalent replacements, improvements and the like within the principle of the disclosure should fall within the protection scope of the claims of the disclosure.

### Industrial Applicability

As mentioned above, a circuit board, a manufacturing method and an electronic device provided by the embodiments of the disclosure have the following beneficial effects: a power via on the circuit board does not have to pass through an optical waveguide layer, which greatly shortens the effective length of the power via, thereby reducing parasitic inductance of the power via, and preventing the parasitic inductance of the power via from influencing seriously the high frequency filtering. Therefore, the problem in the conventional art that the high frequency filtering effect of the power supply in the OE-PCB is poor can be solved, thereby achieving the effect of improving the stability of power supply of the OE-PCB.

## Claims

1. A circuit board, at least comprising a first base layer,
wherein a first planar capacitor set and at least one optical waveguide are provided in a region at a first side of the first base layer; the first planar capacitor set comprises at least one pair of planar capacitors; and the first planar capacitor set and the at least one optical waveguide are arranged side by side in a direction parallel to a plane in which the first base layer is located.

2. The circuit board according to claim 1, wherein the first planar capacitor set is contacted and connected with the first base layer.

3. The circuit board according to claim 2, wherein the first planar capacitor set comprises a first ground plane, and the first ground plane is contacted and connected with the first base layer.

4. The circuit board according to claim 1, wherein the at least one optical waveguide is contacted and connected with the first base layer.

5. The circuit board according to claim 1, wherein a first metal layer is provided between the at least one optical waveguide and the first base layer, and the first metal layer is contacted and connected with the first base layer and the at least one optical waveguide respectively.

6. The circuit board according to claim 5, wherein the first metal layer is connected with a ground plane comprised in the circuit board.

7. The circuit board according to claim 5, wherein the first metal layer is connected with a ground plane in the first planar capacitor set.

8. The circuit board according to claim 1, wherein
a second planar capacitor set is provided in a region at a second side of the first base layer; the second planar capacitor set comprises at least one pair of planar capacitors.

9. The circuit board according to claim 8, wherein the second planar capacitor set is contacted and connected with the first base layer.

10. The circuit board according to claim 9, wherein the second planar capacitor set comprises a second ground plane, and the second ground plane is contacted and connected with the first base layer; or,
the second planar capacitor set comprises a first power plane, wherein the first power plane is contacted and connected with the first base layer.

11. The circuit board according to any one of claims 1 to 10, wherein a via on the circuit board is arranged in a bonding pad of the circuit board.

12. The circuit board according to any one of claims 1 to 10, wherein a power plane of each planar capacitor comprised in the circuit board is provided with one or multiple types of power networks, and the multiple types of power networks are isolated from each other.

13. The circuit board according to any one of claims 1 to 10, wherein a first component is mounted on an outer surface of the circuit board; a power pin and a ground pin of the first component are connected with the planar capacitors comprised in the circuit board through a metalized hole wall, wherein the metalized hole wall is arranged in the via and distributed between the planar capacitors comprised in the circuit board and an outer surface of the circuit board in a direction parallel to an axis of the via.

14. The circuit board according to claim 1, wherein the first planar capacitor set comprises the following structure:
a structure formed by one or more insulating dielectric layers spaced successively among multiple power planes and ground planes.

15. A manufacturing method, used for manufacturing the circuit board according to any one of claims 1 to 14, comprising:
in a region at a first side of at least one first base layer, forming a first planar capacitor set and at least one optical waveguide, wherein the first planar capacitor set and the at least one optical waveguide are distributed side by side in a direction parallel to a plane in which a first base layer is located.

16. The manufacturing method according to claim 15, further comprising:
forming a contacted and connected state between the first planar capacitor set and the first base layer.

17. The manufacturing method according to claim 16, wherein forming the contacted and connected state between the first planar capacitor set and the first base layer comprises:
forming a contacted and connected state between a first ground plane and the first base layer, wherein the first planar capacitor set comprises the first ground plane.

18. The manufacturing method according to claim 15, further comprising:
forming a contacted and connected state between the at least one optical waveguide and the first base layer.

19. The manufacturing method according to claim 15, further comprising:
forming a first metal layer between the at least one optical waveguide and the first base layer, wherein the first metal layer is contacted and connected with the first base layer and the at least one optical waveguide respectively.

20. The manufacturing method according to claim 19, further comprising:
connecting the first metal layer with a ground plane comprised in the circuit board.

21. The manufacturing method according to claim 19, further comprising:
connecting the first metal layer with the ground plane in the first planar capacitor set.

22. The manufacturing method according to claim 15, further comprising:
forming a second planar capacitor set in a region at a second side of the first base layer, wherein the second planar capacitor set comprises at least one pair of planar capacitors.

23. The manufacturing method according to claim 22, further comprising:
forming a contacted and connected state between the second planar capacitor set and the first base layer.

24. The manufacturing method according to claim 23, wherein forming the contacted and connected state between the second planar capacitor set and the first base layer comprises:
forming the contacted and connected state between a second ground plane and the first base layer, wherein the second planar capacitor set comprises the second ground plane; or
forming the contacted and connected state between a first power plane and the first base layer, wherein the second planar capacitor set comprises the first power plane.

25. An electronic device, comprising the circuit board according to any one of claims 1 to 14.
